# EUROPEAN PATENT APPLICATION

(11) **EP 4 438 657 A1**
(43) Date of publication of application: **02.10.2024**
(21) Application number: 24163504.4
(22) Date of filing: 14.03.2024
(51) Int. Cl.: C08G 73/10, H05K 1/00

(54) **POLYAMIC ACID, POLYAMIC ACID COMPOSITION, POLYIMIDE, POLYIMIDE FILM, AND PRINTED CIRCUIT BOARD**

(30) Priority: 27.03.2023 JP 2023050565
(71) Applicant: Tamura Corporation, Tokyo 178-8511 (JP)
(72) Inventor: ENDO, Taiki, Iruma-shi, Saitama (JP); HORI, Atsushi, Iruma-shi, Saitama (JP)
(74) Representative: Zacco GmbH

(57) **Abstract**

The present invention is related to providing a polyamic acid that can form a polyimide exhibiting a low dielectric property and high heat resistance and that has good film formability, and a polyamic acid composition, polyimide, polyimide film, and printed circuit board that are produced by using this polyamic acid. A polyamic acid that is a product obtained by polyaddition reaction between a tetracarboxylic dianhydride (A) and at least two diamines (B), wherein the at least two diamines (B) contain a diamine having a fluorene skeleton (B1) and a dimer diamine (B2).

## Description

### Technical Field

The present invention relates to a polyamic acid that can form a polyimide exhibiting a low dielectric property and high heat resistance and that has good film formability, and a polyamic acid composition, polyimide, polyimide film, and printed circuit board that are produced by using this polyamic acid.

### Background Art

For insulative materials forming mobile telecommunication devices such as smartphones and tablets, and electronic devices such as computers and car navigation systems, high insulation breakdown voltage and heat resistance are required. A polyimide, which is an imidized polymer of a polyamic acid commonly synthesized from an acid dianhydride and an aromatic diamine compound, has excellent heat resistance, mechanical properties, and insulativity, and is therefore widely used for such insulative materials.

In recent years, a printed circuit board for high-speed large-capacity next-generation high-frequency wireless systems has been developed, and adopting a circuit substrate having a multilayer wiring structure enables high-speed transmission of signals. Polyimides are used for an interlayer insulative film in the multilayer wiring structure, but common polyimides have high dielectric properties such as dielectric constant, and thereby cause delays in the transmission of the signals to inhibit increase in the speed. Further, an electrostatic capacity increases with the high dielectric constant, and thereby wiring near the insulative film generates heat in use with high-speed telecommunication (high frequency), and causes malfunction and the like of the printed circuit board.

For a countermeasure of such high frequency, a demand for a polyimide exhibiting a low dielectric property has increased. For example, Patent Literature 1 discloses that a polyimide produced by using an aromatic diamine and tetracarboxylic dianhydride having specific structures exhibits a low dielectric constant and excellent heat resistance.

A known method is decreasing a concentration of imide groups by introducing a fluorene skeleton into a diamine component to decrease the polarity of an entire molecule, and reducing a dielectric constant of the polyimide. For example, J Patent Literature 2 discloses that a polyimide using trimellitic anhydride chloride as an acid anhydride and 9,9-bis(4-aminophenyl)fluorene as a diamine exhibits high heat resistance and low specific dielectric constant.

However, the polyamic acid composition having a fluorene skeleton typically tends to have insufficient film formability, and may fail to yield a polyimide film having good properties. Thus, there has been a demand for providing a polyamic acid that can form a polyimide exhibiting high heat resistance and a low dielectric property and that exhibits good film formability.

### Document List

### Patent Literatures

Patent Literature 1: Japanese Patent Application Laid-Open No. H10-152559
Patent Literature 2: Japanese Patent Application Laid-Open No. 2005-298625

### Summary of Invention

### Technical Problem

It is an object of the present invention to provide a polyamic acid that can form a polyimide exhibiting a low dielectric property and high heat resistance and that has good film formability; and a polyamic acid composition, polyimide, polyimide film, and printed circuit board that are produced by using this polyamic acid.

### Solution to Problem

An aspect of the present invention is a polyamic acid that is a product obtained by polyaddition reaction between a tetracarboxylic dianhydride (A) and at least two diamines (B), wherein the at least two diamines (B) comprise a diamine having a fluorene skeleton (B1) and a dimer diamine (B2).

In an embodiment of the present invention, the diamine having the fluorene skeleton (B1) has a structure represented by the following formula (1): 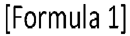 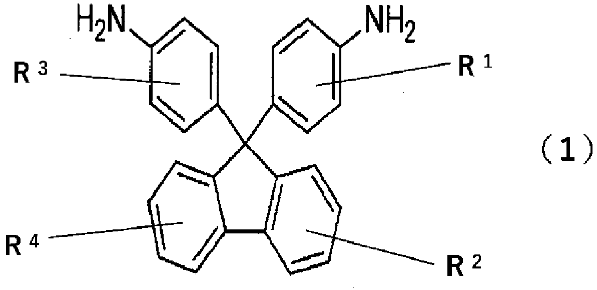 wherein R¹ to R⁴ each independently represent a hydrogen atom, a halogen atom, a C₁ to C₈ alkyl group, or a C₁ to C₈ halogenated alkyl group.

Another aspect of the present invention is a polyamic acid composition comprising the above polyamic acid and an organic solvent (C).

Another aspect of the present invention is a polyimide obtained by imidizing the above polyamic acid.

Another aspect of the present invention is a polyimide film comprising the above polyimide.

Another aspect of the present invention is a printed circuit board comprising the above polyimide film.

### Effects of Invention

According to the present invention, the polyamic acid that can form a polyimide exhibiting a low dielectric property and high heat resistance and that has good film formability, and the polyamic acid composition, polyimide, polyimide film, and printed circuit board that are produced by using this polyamic acid can be provided.

### Description of Embodiments

Hereinafter, embodiments of the present invention will be described in detail. A polyamic acid of the present invention is a product obtained by polyaddition reaction between a tetracarboxylic dianhydride (A) and at least two diamines (B), wherein the at least two diamines (B) contain a diamine having a fluorene skeleton (B1) and a dimer diamine (B2). That is, the polyamic acid of the present invention and the polyimide formed by using this polyamic acid have a fluorene skeleton and a dimer skeleton. If only the diamine having the fluorene skeleton is contained as the diamine component, sufficient film formability is not imparted to the polyamic acid. Meanwhile, if only the diamine having the dimer skeleton is contained as the diamine component, a polyimide exhibiting the low dielectric property can be formed but sufficient heat resistance is not imparted to the polyimide, and mechanical properties are also deteriorated. In the present invention, the polyamic acid having both the fluorene skeleton and the dimer skeleton can form the polyimide exhibiting the low dielectric property and the high heat resistance, and the insufficient film formability of the polyamic acid derived from the fluorene skeleton is improved to be able to achieve the polyamic acid exhibiting the good film formability.

### (A) Tetracarboxylic Dianhydride

The polyamic acid of the present invention has a structural unit derived from the tetracarboxylic dianhydride in a molecule as an acid dianhydride component. The tetracarboxylic dianhydride may be any of an alicyclic tetracarboxylic dianhydride, an aromatic tetracarboxylic dianhydride, and an aliphatic tetracarboxylic dianhydride, and has two acid anhydride groups in one molecule. One tetracarboxylic dianhydride may be used, or two or more thereof may be used in combination.

Examples of the alicyclic tetracarboxylic dianhydride include 1,2,3,4-cyclobutanetetracarboxylic dianhydride, 1,2,3,4-cyclopentanetetracarboxylic dianhydride, 3-carboxymethylcyclopentane-1,2,4-tricarboxylic dianhydride, 1,2,3,4-cyclohexanetetracarboxylic dianhydride, 1,2,4,5-cyclohexanetetracarboxylic dianhydride, bicyclo[2.2.1]heptanetetracarboxylic dianhydride, bicyclo[2.2.1]heptane-5-carboxymethyl-2,3,6-tricarboxylic dianhydride, bicyclo[2.2.2]oct-7-ene-2,3,5,6-tetracarboxylic dianhydride, bicyclo[2.2.2]octane-2,3,5,6-tetracarboxylic dianhydride, pentacyclo[8.2.1.1^{4.7}.0^{2.9}.0^{3.8}]tetradecane-5,6,11,12-tetracarboxylic dianhydride, 5-(2,5-dioxotetrahydrofuryl)-3-methyl-3-cyclohexene-1,2-dicarboxylic anhydride, bicyclo[2.2.1]heptane-2-carboxymethyl-2,5,6-tricarboxylic dianhydride, bicyclo[2.2.2]octane-2-carboxyethyl-2,5,6-tricarboxylic dianhydride, 3,3',4,4'-dicyclohexyltetracarboxylic dianhydride, and derivatives thereof.

Examples of the aromatic tetracarboxylic dianhydride include 3,3',4,4'-diphenylsulfonetetracarboxylic dianhydride, 3,3'4,4'-benzophenonetetracarboxylic dianhydride, 4,4'-oxydiphthalic dianhydride, pyromellitic dianhydride, 2,2'3,3'-benzophenonetetracarboxylic dianhydride, 3,3',4,4'-biphenyltetracarboxylic dianhydride, 2,2'3,3'-biphenyltetracarboxylic dianhydride, 2,2-bis(3,4-dicarboxyphenyl)propane dianhydride, 2,2-bis(2,3-dicarboxyphenyl)propane dianhydride, 2,2-bis(3,4-dicarboxyphenoxyphenyl)propane dianhydride, 1,1-bis(2,3-dicarboxyphenyl)ethane dianhydride, 1,2-bis(2,3-dicarboxyphenyl)ethane dianhydride, 1,1-bis(3,4-dicarboxyphenyl)ethane dianhydride, 1,2-bis(3,4-dicarboxyphenyl)ethane dianhydride, bis(2,3-dicarboxyphenyl)methane dianhydride, bis(3,4-dicarboxyphenyl)methane dianhydride, 4,4'-(p-phenylenedioxy)diphthalic dianhydride, 4,4'-(m-phenylenedioxy)diphthalic dianhydride, 2,3,6,7-naphthalenetetracarboxylic dianhydride, 1,4,5,8-naphthalenetetracarboxylic dianhydride, 1,2-ethylenebis(anhydrotrimellitate), 1,4-phenylenebis(anhydrotrimellitate), 1,3,3a,4,5,9b-hexahydro-5-(tetrahydro-2,5-dioxo-3-furanyl)naphtho[1,2-c]furan-1,3-dione, and derivatives thereof.

Examples of the aliphatic tetracarboxylic dianhydride include 1,2,3,4-butanetetracarboxylic dianhydride, 1,2,3,4-pentanetetracarboxylic dianhydride, and derivatives thereof.

Among these tetracarboxylic dianhydrides, the acid dianhydride component is preferably the aromatic tetracarboxylic dianhydride, and among the aromatic tetracarboxylic dianhydride, pyromellitic dianhydride is preferable.

### (B) Diamine

The polyamic acid of the present invention has a structural unit derived from at least two diamines as the diamine component, and one of the diamine components has a structural unit derived from a diamine having a fluorene skeleton (B1). Such a diamine having a fluorene skeleton preferably has a structure represented by the following formula (1). In the formula (1), R¹ to R⁴ each independently represent a hydrogen atom, a halogen atom, a C₁ to C₈ alkyl group, or a C₁ to C₈ halogenated alkyl group. R¹ to R⁴ may be the same as or different from each other.

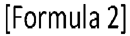

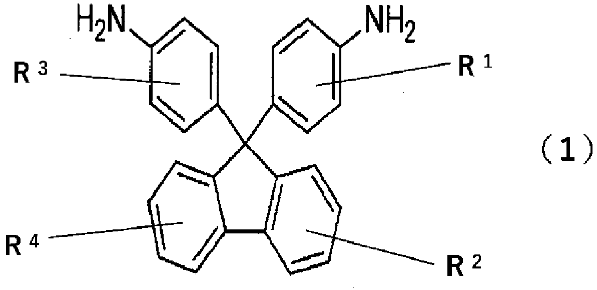

The C₁ to C₈ alkyl group is preferably a C₁ to C₄ alkyl group, more preferably an ethyl group or a methyl group, and further preferably a methyl group. The halogen atom is a fluorine atom, a chlorine atom, a bromine atom, or an iodine atom, and is preferably a fluorine atom or a chlorine atom. Examples of the C₁ to C₈ halogenated alkyl group include a halogenated alkyl group in which a hydrogen atom in the above C₁ to C₈ alkyl group is substituted with the above halogen atom.

R¹ to R⁴ preferably represent a hydrogen atom or the C₁ to C₈ alkyl group, and R¹ to R⁴ particularly preferably represent all hydrogen atoms.

Preferable examples of the diamine having a fluorene skeleton represented by the formula (1) include a compound represented by the following formula (1-1), namely 9,9-bis(4-aminophenyl)fluorene.

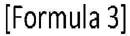

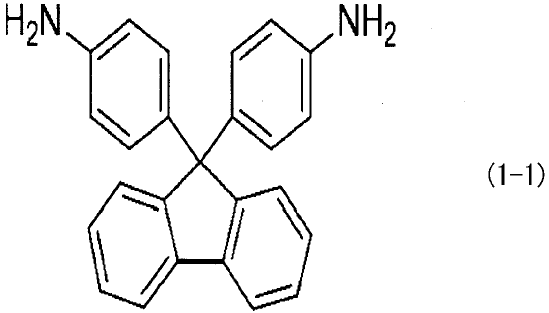

The polyamic acid of the present invention has a structural unit derived from a dimer diamine (B2) as another diamine component. Here, the dimer diamine means an aliphatic diamine in which two terminal carboxylic acid groups (-COOH) of a cyclic or acyclic dimer acid obtained as a dimer of an unsaturated fatty acid are substituted with a primary aminomethyl group (-CH₂-NH₂) or an amino group (-NH₂). The polyamic acid having the structural unit derived from the dimer diamine can impart the low dielectric property to the obtained polyimide. One dimer diamine may be used, or two or more thereof may be used in combination.

The dimer acid is a dibasic acid obtained by an intermolecular polymerization reaction of the unsaturated fatty acid. The aliphatic diamine derived from the dimer acid is obtained by: polymerizing the unsaturated fatty acid such as, for example, oleic acid, linoleic acid, and linolenic acid to form the dimer acid; and reducing and then aminating this dimer acid. Such a dimer diamine is preferably a diamine compound obtained by substituting terminal carboxylic acid groups of a dibasic acid compound having carbon atoms within a range of 18 to 54, preferably within a range of 22 to 44, with a primary aminomethyl group or an amino group.

Examples of commercial products of the dimer diamine include: "Versamine (R) 551" and "Versamine (R) 552", manufactured by Cognis Japan Ltd.; and "PRIAMINE (R) 1073", "PRIAMINE (R) 1074", and "PRIAMINE (R) 1075", manufactured by Croda Japan KK.

In the polyamic acid of the present invention, a molar ratio of the diamine having a fluorene skeleton (B1) relative to the entirety of the diamine component is not particularly limited, but is preferably 0.25 or more, and more preferably 0.50 or more.

A molar ratio of the diamine to the tetracarboxylic dianhydride [(B)/(A)] is not particularly limited, but is preferably 0.90 to 1.10, more preferably 0.95 to 1.05, further preferably 0.97 to 1.03, and particularly preferably 0.98 to 1.02.

### <Polyamic Acid and Polyamic Acid Composition>

### (C) Organic Solvent

The polyamic acid of the present invention can be synthesized by a known common method. For example, the tetracarboxylic acid dianhydride and the diamine are reacted in an organic solvent (C) to obtain a polyamic acid composition (polyamic acid solution). The organic solvent used for the polymerization of the polyamic acid is not particularly limited as long as the solvent can dissolve the tetracarboxylic dianhydride and the diamine as monomer components, and can dissolve the polyamic acid generated by the polyaddition reaction. Examples of such an organic solvent include: urea solvents such as tetramethylurea and N,N-dimethylethylurea; sulfone solvents such as dimethyl sulfoxide, diphenyl sulfone, and tetramethylsulfone; amide solvents such as N,N-dimethylacetamide, N,N-dimethylformamide, N,N-diethylacetamide, N-methyl-2-pyrrolidone, and hexamethylphosphoric triamide; ester solvents such as γ-butyrolactone; halogenated alkyl solvents such as chloroform and methylene chloride; aromatic hydrocarbon solvents such as benzene and toluene; phenol solvents such as phenol and cresol; ketone solvents such as cyclopentanone; and ether solvents such as tetrahydrofuran, 1,3-dioxolane, 1,4-dioxane, dimethyl ether, diethyl ether, and p-cresol methyl ether. These organic solvents may be used singly, or may be used in combinations of two or more thereof. From the viewpoint of improvement of solubility and reactivity of the polyamic acid, the organic solvent is preferably selected from the group consisting of the amide solvents, the ketone solvents, the ester solvents, and the ether solvents, and preferably the amide solvents such as N,N-dimethylacetamide, N,N-dimethylformamide, N,N'-diethylacetamide, and N-methyl-2-pyrrolidone.

Regulating a molar ratio between: the number of moles of the total amount of the tetracarboxylic dianhydride component; and the number of moles of the total amount of the diamine component can regulate a molecular weight of the polyamic acid. The molecular weight (weight-average molecular weight) of the polyamic acid is not particularly limited, but preferably 10,000 or more and 100,000 or less from the viewpoint of solubility in the organic solvent. The weight-average molecular weight of the polyamic acid can be determined from a value in terms of standard polystyrene by gel permeation chromatography (GPC) measurement, for example.

The synthesis of the polyamic acid by the polyaddition reaction between the tetracarboxylic dianhydride and the diamine is preferably performed in an inert atmosphere such as argon and nitrogen. The polyaddition reaction proceeds by dissolving and mixing the tetracarboxylic dianhydride and the diamine in the organic solvent in the inert atmosphere. An addition order of the tetracarboxylic dianhydride and the diamine is not particularly limited. For example, the diamine may be dissolved or dispersed like a slurry in the organic solvent to form a diamine solution, and the tetracarboxylic dianhydride may be added into the diamine solution. The tetracarboxylic dianhydride and the diamine may be directly added into the organic solvent in a solid state, or may be added in a state where the tetracarboxylic dianhydride and the diamine are separately dissolved or dispersed like a slurry in the organic solvent.

A temperature condition of the polyaddition reaction is not particularly limited. The reaction temperature is preferably 100°C or lower from the viewpoint of inhibiting decrease in the molecular weight of the polyamic acid due to depolymerization, and the reaction temperature is more preferably 20 to 80°C from the viewpoint of appropriately progressing the polyaddition reaction. The reaction time is freely set within a range of 1 to 72 hours, and the resultant may be further left to stand overnight at room temperature as necessary.

A viscosity of the solution when the polyamic acid composition of the present invention is prepared is preferably 500 mPa·s or more from the viewpoint of film formability. A concentration of the polyamic acid in the polyamic acid composition of the present invention is preferably 15 mass% or more, and more preferably 25 mass% or more. In particular, when the concentration of the polyamic acid is 25 mass% or more, productivity of forming a polyimide coating using the polyamic acid can be improved. An upper limit of the concentration of the polyamic acid is preferably 50 mass% or less, and further preferably 30 mass% or less from the viewpoint of sufficiently dissolving the polyamic acid in the organic solvent.

To impart processing properties and functionalities to the polyamic acid and the polyimide formed by using this polyamic acid, various organic or inorganic low-molecular-weight compound or polymer compound may be blended with the polyamic acid composition. For example, the polyamic acid composition may contain a dye, a surfactant, a leveling agent, a plasticizer, fine particles, a sensitizer, and a silane coupling agent. The fine particles may be any of organic fine particles and inorganic fine particles, and may have a porous or hollow structure.

### <Polyimide>

A method for converting the polyamic acid into the polyimide is not particularly limited, and the polyimide can be manufactured by dehydration and cyclization (imidization) of the polyamic acid obtained as described above. As the method for the dehydration and cyclization (imidization), known methods such as a thermal imidization of dehydration and cyclization by heating, a chemical imidization of chemical cyclization by using a known dehydration and cyclization catalyst, and the like can be adopted.

In a case of the thermal imidization, the heating temperature is preferably 120 to 350°C, and more preferably 150 to 250°C. The heating time is preferably 0.5 to 3 hours, and more preferably 1 to 2 hours. In a case of the chemical imidization, pyridine, triethylamine, acetic anhydride, and the like can be used as the dehydration and cyclization catalyst, for example. In this case, any temperature within 20 to 250°C can be selected as the reaction temperature. The temperature is preferably 100°C or lower, and the reaction time is preferably 0.5 to 3 hours. Although the imidization may be performed under air, under a reduced pressure, or in an inert gas such as nitrogen, the imidization is preferably performed under a reduced pressure or in an inert gas such as nitrogen to obtain a highly transparent polyimide film.

A molecular weight (weight-average molecular weight) of the polyimide is not particularly limited, but is preferably 10,000 or more and 100,000 or less from the viewpoint of the low dielectric property, the film formability, and the solubility in the organic solvent of the obtained polyimide. The weight-average molecular weight of the polyimide can be determined from a value in terms of standard polystyrene by gel permeation chromatography (GPC) measurement, for example.

### <Polyimide Film>

The polyimide film of the present invention contains the polyimide obtained above. A method for manufacturing such a polyimide film is not particularly limited, and examples of the method include: a method including applying the above polyamic acid composition onto a substrate (for example, a plastic film such as polyethylene, polypropylene, urethane, polyester, polyethylene terephthalate (PET), or polycarbonate, a glass plate, a stainless steel plate, a copper plate including a very thin copper foil, an aluminum plate, or the like) in a film form, and then drying and heating the film to remove the solvent, and performing the dehydration and cyclization (imidization); and a method including dissolving the polyimide obtained by converting the polyamic acid into the polyimide in the organic solvent, applying the polyimide solution onto a substrate in a film form, and drying the film to remove the solvent. The method of application onto the substrate is not particularly limited, and conventionally known methods of application can be employed.

A thickness of the polyimide film is not particularly limited, and may be appropriately selected depending on the use. The thickness of the polyimide film is preferably 10 to 100 µm, and more preferably 20 to 30 µm. The thickness of the polyimide film can be easily controlled by appropriately regulating a solid-content concentration of each component in the polyamic acid composition and the viscosity.

### <Printed circuit board>

The polyimide film of the present invention is suitably used as a film for members such as a color filter, a flexible display, a semiconductor component, and an optical component. Since the polyimide film exhibits insulativity, the polyimide film is suitably employed as an insulative substrate of a printed circuit board. In addition, since the polyimide film is an insulative, thin, and flexible film, the polyimide film is effectively employed as a base film of a bendable circuit substrate called flexible printed circuit (FPC).

### Example

Thereafter, Examples of the present invention will be described. However, the present invention is not limited to these examples as long as not departing from the spirit of the present invention.

### <Examples 1 to 2 and Comparative Examples 1 to 3>

An organic solvent in which each diamine shown in the following Table 1 was dissolved was fed into a separable flask at a blending ratio shown in the following Table 1, and then a tetracarboxylic dianhydride shown in the following Table 1 was fed in this order at a blending ratio shown in the following Table 1, and the obtained mixture was stirred at 50°C for 3.5 hours and further stirred at room temperature for 24 hours to prepare a polyamic acid composition used in Examples 1 to 2 and Comparative Examples 1 to 3. The prepared polyamic acid composition was applied onto a substrate by using a specimen-producing step, described later, to produce a specimen. By using the produced specimen, properties shown in the following Table 1 were each evaluated. Table 1 shows the evaluation results. Note that the blending amount of each component shown in the following Table 1 is represented on parts by mass unless otherwise mentioned.

**[Table 1]**

| Polyamic acid composition | | | Example 1 | Example 2 | Comparative Example 1 | Comparative Example 2 | Comparative Example 3 |
|---|---|---|---|---|---|---|---|
| (A) Acid anhydride | Tetracarboxylic dianhydride | PMDA | 10.91 | 10.91 | 10.91 | 10.91 | 1091 |
| (B) Diamine | (B1) Fluorene-skeleton diamine | 9,9-Bis(4-aminophenyl)fluorene | 8.71 | 13.07 | | | 17.42 |
| | (B2) Dimer diamine | PRIAMINE 1075 | 13.35 | 6.68 | | 26.70 | |
| | (B3) Aromatic diamine | 4,4'-ODA | | | 10.01 | | |
| (C) Organic solvent | Amide solvent | NMP | 76.94 | 91.72 | 43.62 | 87.70 | 112.82 |
| Molar ratio of component (B) to component (A) | | | 1.00 | 1.00 | 1.00 | 1.00 | 1.00 |
| Molar ratio of component (B1) relative to total amount of component (B) | | | 0.50 | 0.75 | - | - | 1.00 |

| Evaluation of polyamic acid I polyimide | | | Evaluation results | | | | |
|---|---|---|---|---|---|---|---|
| Film formability | | | Good | Fair | Good | Good | Poor |
| Heat resistance | Glass transition temperature Tg [°C] | | 128 | 227 | unmeasured | 64 | - |
| | Coefficient of thermal expansion CTE a1 | | 117 | 85 | unmeasured | 450 | - |
| | Pyrolysis resistance Td5 [°C] | | 458 | 445 | unmeasured | 440 | - |
| Dielectric property | Dielectric constant | | 2.40 | 2.79 | 3.70 | 1.70 | - |
| | Dielectric loss tangent | | 0.0014 | 0.0084 | 0.0277 | 0.0016 | - |
| Mechanical strength | Elastic modulus [GPa] | | 0.99 | 1.37 | unmeasured | 0.14 | - |

Details of each component in Table 1 were as follows.
(A) Tetracarboxylic Dianhydride
PMDA: pyromellitic dianhydride
(B1) Fluorene-skeleton diamine
BAF: 9,9-Bis(4-aminophenyl)fluorene
(B2) Dimer Diamine
PRIAMINE (R) 1075: manufactured by Croda Japan KK, Dimer Diamine
(B3) Aromatic Diamine
4,4'-ODA: 4,4'-oxydianiline
(C) Organic Solvent
NMP: N-methyl-2-pyrrolidone

### <Specimen-Producing Step>

A PET film ("Very-low Adhesion Sheet for Processing PET 75", manufactured by NEION Film Coatings Corp., thickness 75 µm) as the substrate was surface-treated (defatting-treated) with isopropyl alcohol, and then each of the polyamic acid compositions prepared in Examples 1 to 2 and Comparative Examples 1 to 3 was applied onto this substrate by using a bar coater, and thereafter subjected to a thermal treatment at 150°C for 1 hour and 180°C for 30 minutes for thermal curing to form a cured coating (polyimide film) having a predetermined thickness on the substrate, and to produce the specimen.

### <Evaluations>

### (1) Film Formability

In the specimen-producing step, a specimen was produced so that the thickness of the cured coating was 50 µm ± 10 µm. The formed cured coating was visually observed and evaluated as follows: a case where aggregation or cracking of the coating was not observed and the coating had sufficient toughness was evaluated as "Good"; a case where aggregation or cracking of the coating was not observed but the coating had insufficient toughness was evaluated as "Fair"; and a case where aggregation or cracking of the coating was observed was evaluated as "Poor".

### (2) Glass Transition Temperature Tg and Coefficient of Thermal Expansion CTE

In the specimen-producing step, a specimen was produced so that the thickness of the cured coating was 50 µm ± 10 µm. Then, the formed cured coating was peeled from the substrate and cut to a predetermined size to prepare a sample. By using a thermomechanical analyzer (manufactured by Hitachi High-Tech Science Corporation, "TMA/SS6000"), a glass transition temperature Tg [°C] and a coefficient of thermal expansion CTEα1 (0°C to 100°C) of the sample were measured.

### (3) Pyrolysis Resistance

In the specimen-producing step, a specimen was produced so that the thickness of the cured coating was 30 µm ± 10 µm. The obtained specimen was finely cut to prepare a sample. On the sample, a temperature at which the weight was reduced by 5% under an air atmosphere at a heating rate of 10°C/min was measured by using a thermogravimeter (manufactured by Hitachi High-Tech Science Corporation, thermogravimeter "STA 7200RV") to evaluate the temperature as a pyrolysis resistant temperature (Td5) [°C].

### (4) Dielectric Constant and Dielectric Loss Tangent

In the specimen-producing step, a specimen was produced so that the thickness of the cured coating was 25 µm ± 10 µm. Then, the obtained specimen was cut to have a length of 50 mm and a width of 1.75 mm to prepare a sample, and a dielectric constant and a dielectric loss tangent were each measured with a cavity resonance method by using a network analyzer and a cavity resonator manufactured by Keysight Technologies under conditions of measurement temperature of 25°C, measurement humidity of 50 RH%, and frequency of 10 GHz.

### (5) Elastic Modulus

In the specimen-producing step, a specimen was produced so that the thickness of the cured coating was 50 µm ± 10 µm. Then, the formed cured coating was peeled from the substrate and cut to a predetermined size to prepare a sample. By using an autograph manufactured by SHIMADZU CORPORATION, an elastic modulus was measured under a condition of tensile speed of 5 mm/min.

As shown in Table 1, in both of Examples 1 to 2, which used the polyamic acid obtained by the polyaddition reaction between the tetracarboxylic dianhydride and the diamine containing both the diamine having a fluorene skeleton and the dimer diamine, the evaluation of the film formability was "Fair" or better, and the polyamic acid exhibiting good film formability was produced. The polyamic acid exhibited a high glass transition temperature Tg and a low coefficient of thermal expansion CTE, and further exhibited low dielectric constant and dielectric loss tangent, and thereby the polyimide exhibiting the low dielectric property and the high heat resistance was produced.

Meanwhile, Comparative Example 1, which did not contain neither the diamine having a fluorene skeleton and the dimer diamine and used the common aromatic diamine as the diamine component, exhibited excellent film formability but higher dielectric constant and dielectric loss tangent than Examples 1 to 2, and failed to produce the polyimide exhibiting the desired low dielectric property. Note that Comparative Example 1 exhibited a high dielectric property, and thereby the other properties were not measured/evaluated.

Comparative Example 2, which did not contain the diamine having a fluorene skeleton and used only the dimer diamine as the diamine component, exhibited excellent film formability and low values of dielectric constant and dielectric loss tangent but exhibited a lower glass transition temperature Tg than Examples 1 to 2 and further exhibited a high coefficient of thermal expansion CTE, and thereby failed to produce the polyimide exhibiting the desired high heat resistance.

In Comparative Example 3, which did not contain the dimer diamine and used only the diamine having a fluorene skeleton as the diamine component, aggregation or cracking of the coating was observed, and failed to produce the polyamic acid exhibiting the good film formability. Note that, in Comparative Example 3, aggregation or cracking of the coating was observed, and thereby the polyimide was failed to be produced and the other properties were not measured/evaluated.

The polyamic acid of the present invention not only exhibits the good film formability but also can form the polyimide exhibiting the low dielectric property and the high heat resistance and further exhibiting good mechanical strength, and thereby the polyimide film produced by using such a polyimide has high utility value as, for example, an insulative substrate of a printed circuit board, specifically a base film of a flexible printed circuit.

## Claims

1. A polyamic acid that is a product obtained by polyaddition reaction between a tetracarboxylic dianhydride (A) and at least two diamines (B), wherein
the at least two diamines (B) comprise a diamine having a fluorene skeleton (B1) and a dimer diamine (B2).

2. The polyamic acid according to claim 1, wherein the diamine having a fluorene skeleton (B1) has a structure represented by the following formula (1): 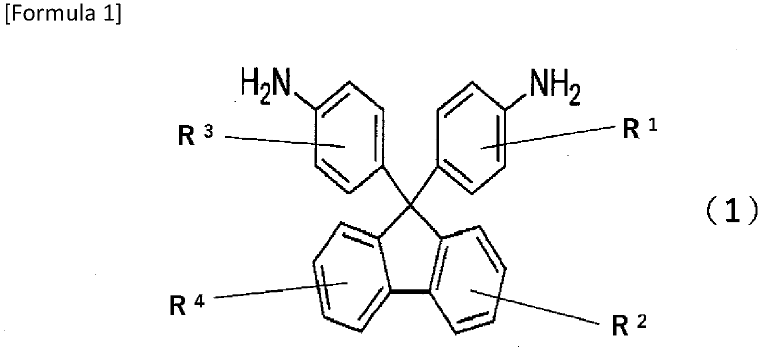 wherein R¹ to R⁴ each independently represent a hydrogen atom, a halogen atom, a C₁ to C₈ alkyl group, or a C₁ to C₈ halogenated alkyl group.

3. A polyamic acid composition comprising:
the polyamic acid according to claim 1 or 2; and
an organic solvent (C).

4. A polyimide obtained by imidizing the polyamic acid according to any one of claims 1 to 3.

5. A polyimide film, comprising the polyimide according to claim 4.

6. A printed circuit board, comprising the polyimide film according to claim 5.
